Europäisches Patentamt

European Patent Office

Office européen des brevets

(19)

(11) Numéro de publication : **0 594 488 A1**

# (12) DEMANDE DE BREVET EUROPEEN

(21) Numéro de dépôt : **93402553.7**

(22) Date de dépôt : **18.10.93**

(51) Int. Cl.⁵ : **G01R 31/26,** G01R 29/26, G01R 35/00

(30) Priorité : **19.10.92 FR 9212465**

(43) Date de publication de la demande :
**27.04.94 Bulletin 94/17**

(84) Etats contractants désignés :
**DE GB**

(71) Demandeur : **FRANCE TELECOM**
**6, Place d'Alleray**
**F-75015 Paris (FR)**

(72) Inventeur : **Boudiaf, Ali**
**6, Place du Colonel Fabien**
**F-75019 Paris (FR)**
Inventeur : **Hassaine, Nacer**
**198 Av. du Général de Gaulle**
**F-94500 Champigny (FR)**
Inventeur : **Konczykowska, Agnieszka**
**9bis chemin du Tennis**
**F-94240 L'Hay Les Roses (FR)**

(74) Mandataire : **Martin, Jean-Jacques et al**
**Cabinet REGIMBEAU 26, Avenue Kléber**
**F-75116 Paris (FR)**

(54) **Elément de test passif simulant le comportement au bruit d'un transistor.**

(57) La présente invention concerne un element de test passif simulant le comportement au bruit d'un transistor, caractérisé par le fait qu'il comprend sur un substrat électriqument isolant : un premier ensemble (100) comportant au moins une piste principale (110) en matériau électriquement conducteur, reliée à un port d'entrée (120), et aboutissant sur un circuit ouvert (140), un second ensemble (200) comportant au moins une piste secondaire (210) en matériau électriquement conducteur, adjacente à ladite piste pricipale (110) pour être couplée à celle-ci, et qui aboutit à un port de sortie (220), et un troisième ensemble (300) comportant au moins une piste auxiliaire (310) en matériau électriquement conducteur, adjacente à ladite piste principale (110) pour être couplée à celle-ci, et qui est reliée à une résistance de charge (320) de valeur contrôlée.

FIG. 1

La présente invention concerne le domaine de la mesure des paramètres de bruit de transistors, sous pointes.

Le test sous pointes des transistors est devenu une pratique courante dans les laboratoires de développement, ainsi que dans les unités industrielles de production.

Plus précisément les spécialistes en la matière procèdent généralement à la détermination de quatre paramètres de bruit des transistors :

- le facteur de bruit minimal : $F_{min}$
- la résistance équivalente de bruit : $R_n$
- le module du coefficient de réflexion optimal $\Gamma_{opt}$ et
- la phase de ce coeffcent de réflexion optimal.

Ces paramètres sont définis par la relation :

$$F = F_{min} + 4 R_n | \Gamma_{opt} - \Gamma_s |^2 / Z_o | 1 + \Gamma_{opt} |^2 (1 - | \Gamma_s |^2 )$$

dans laquelle :

F représente le facteur de bruit mesuré,

$\Gamma_s$ représente le coefficient mesuré de réflexion de la source, et

$Z_o$ représente une impédance de 50 Ohms.

Ces quatre paramètres de bruit sont bien connus de l'homme de l'art.

La caractérisation hyperfréquence et plus particulièrement la détermination des quatre paramètres de bruit précités des transistors représente aujourd'hui un outil indispensable, très puissant, servant aussi bien dans l'optimisation des processus de fabrication que dans la conception des circuits pour les télécommunications.

Les premiers bancs automatiques de mesure des paramètres de bruit sous pointes ont été commercialisés en 1987 par deux firmes américaines ATN et CASCADE Microtech. Les. premiers éléments de test utilisés dans les anciens bancs de bruit (accès coaxiaux), étaient des atténuateurs, 3dB généralement. Ces éléments permettent de vérifier si la mesure du facteur de bruit correspond bien au calcul du gain disponible à partir des paramètres de dispersion (Sij) mesurés, ou directement de la mesure de gain sous 50 Ohms. La Société CASCADE Microtech propose de mesurer un diviseur avec une sortie terminée par un circuit ouvert. Ce dispositif présente un facteur de bruit plus petit, de l'ordre de 1 dB à 3 GHz. "DAVIDSON A.,LEAKE B., STRID E., Accuracy improvements in microwave noise parameter measurements, IEEE Trans MTT, 1989, vol 37, pp 1973-1978".

L'utilisation de diviseurs présente les avantages de la simplicité de fabrication, de la précision et de la reproductibilité.

Toutefois cette technique présente en revanche les inconvénients de délivrer des paramètres de bruit différents de ceux d'un transistor actif, et d'une faible influence de la correction du récepteur.

Pour tenter d'éliminer ces inconvénients, on a proposé plus récemment de mesurer les paramètres de bruit d'un transistor à effet de champ froid, c'est à dire non polarisé, monté en grille commune. "ESCOTTE L., PLANA R., Using cold FET to check accuracy of microwave noise parameter test set, Electronics Letters, 9 May 1991, pp 833-835". Cette technique conduit à des paramètres de bruit mesurés sur le dispositif passif, qui sont du même ordre de grandeur que les paramètres de bruit d'un transistor actif monté et polarisé en source commune. De plus l'influence de la correction du récepteur sur la mesure n'est que moyenne. Cette technique nouvelle présente donc des avantages par rapport aux techniques de mesure anciennes précédemment invoquées. Toutefois la mesure des paramètres de bruit sur un transistor à effet de champ froid entraine des difficultés de fabrication car elle nécessite un process spécifique. De plus cette technique crée des problèmes de précision et de reproductibilité. Enfin cette technique n'est pas extensible en fréquence.

La présente invention a maintenant pour but de proposer de nouveaux moyens qui permettent d'améliorer la mesure des paramètres de bruit sous pointes.

Ce but est atteint selon la présente invention grâce à un élément de test passif simulant le comportement au bruit d'un transistor et qui comprend, sur un substrat électriquement isolant :

- un premier ensemble comportant au moins une piste principale en matériau électriquement conducteur reliée à un port d'entrée, et aboutissant sur un circuit ouvert,
- un second ensemble comportant au moins une piste secondaire en matériau électriquement conducteur, adjacente à ladite piste principale pour être couplée à celle-ci, et qui aboutit à un port de sortie, et
- un troisième ensemble comportant au moins une piste auxiliaire en matériau électriquement conducteur, adjacente à ladite piste principale pour être couplée à celle-ci, et qui est reliée à une résistance de charge de valeur contrôlée.

D'autres caractéristiques, buts et avantages de la présente invention apparaitront à la lecture de la description détaillée qui va suivre et en regard des dessins annexés, donnés à titre d'exemples non limitatifs et sur lesquels :

- la figure 1 annexée représente une vue d'un élément de test conforme à un mode de réalisation préférentiel de la présente invention,
- la figure 2 représente le facteur de bruit minimal $F_{min}$ obtenu d'une part par simulation à l'aide d'un logicial HP-MDS et d'autre part résultant de la mesure sur un élément de test conforme à l'invention,
- la figure 3 représente la résistance équivalente de bruit $R_n$ obtenue d'une part par simulation à l'aide du même logiciel, et d'aute part résultant de la mesure sur un élément de test conforme à l'invention,

- la figure 4 représente le module du coefficient de réflexion optimal obtenu d'une part, par simulation à l'aide du même logiciel, et d'autre part résultant de la mesure sur un élément de test conforme à l'invention,
- la figure 5 représente la phase du module de coefficient de réflexion optimal obtenu, d'une part par simulation à l'aide du même logiciel, et d'autre part résultant de la mesure sur un élément de test conforme à l'invention,
- la figure 6 représente les paramètres Sij mesurés et simulés dans les mêmes conditions,
- les figures 7, 8, 9 et 10 représentent les quatres paramètres de bruit précités résultant de simulations, sur un élément de test conforme à la présente invention, en faisant varier les conditions de charge sur la sortie du troisième ensemble de l'élément conforme à la présente invention.

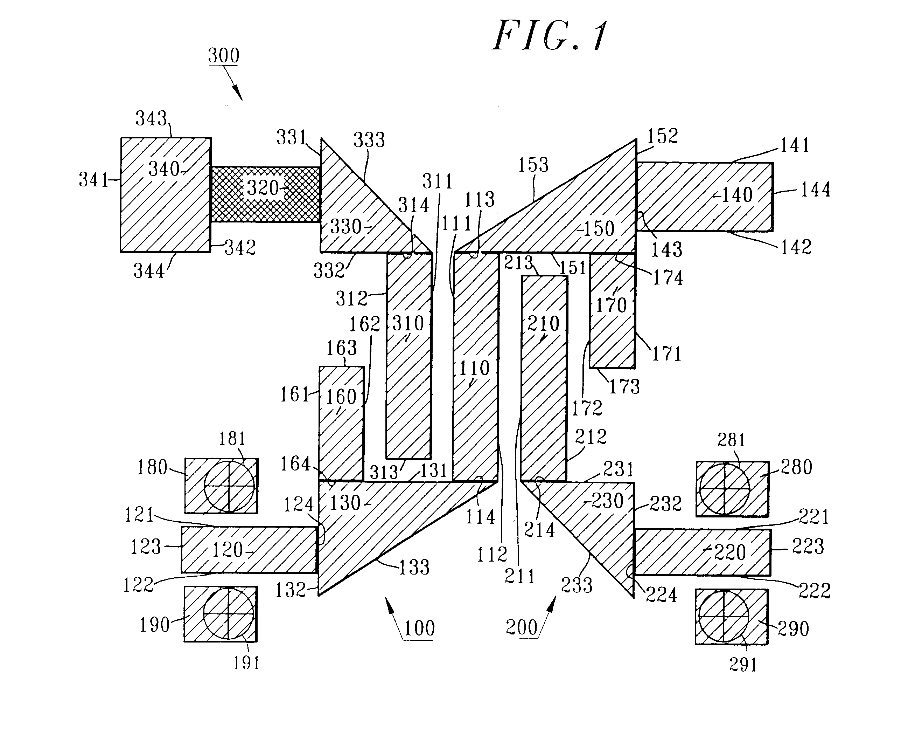

Comme indiqué précédemment, l'élément de test conforme à la présente invention comprend essentiellement trois ensembles. Ceux-ci sont référencés respectivement 100, 200 et 300 sur la figure 1 annexée.

La description détaillée qui va suivre sera faite en référence à une direction longitudinale de l'élément référencée D sur la figure 1 annexée.

Les trois ensembles 100, 200 et 300 sont formés de pistes électriquement conductrices placées sur un substrat électriquement isolant.

Le premier ensemble 100 comporte au moins une piste principale 110 en matériau électriquement conducteur reliée à un port d'entrée 120 et qui aboutit à un circuit ouvert 140.

La piste principale 110 possède un contour rectangulaire. Ses grands côtés sont référencés 111, 112. Ses petits côtés sont référencés 113, 114. Les grands côtés 111, 112 de la plage principale 110 sont orientés parallèlement à la direction longitudinale D précitée.

Le port d'entrée 120 est formé d'une piste de contour rectangulaire. Les grands côtés du port d'entrée 120 sont référencés 121, 122. Les petits côtés du port d'entrée 120 sont référencés 123, 124. Les grands côtés 121, 122 du port d'entrée sont orientés perpendiculairement à la direction longitudinale D.

Le port d'entrée 120 et la piste principale 110 sont reliés par une piste électriquement conductrice 130. La piste 130 présente un contour triangulaire droit. Les deux côtés orthogonaux 131, 132 de la piste 130 sont respectivement perpendiculaire à la direction D et parallèle à celle-ci. La piste principale 110 se raccorde à la piste de liaison 130 sur le côté 131 de celle-ci. Le côté 131 de la piste de liaison 130 est de préférence très largement supérieur à la largeur de la piste principale 110, c'est-à-dire à la longueur du petit côté 114. Le port d'entrée 120 se raccorde à la piste de liaison 130 sur le côté 132 de celle-ci. De préférence, le côté 132 de la piste de liaison 130 est également très largement supérieur à la largeur du port d'entrée 120, c'est-à-dire à la longueur du petit côté 124. De préférence, la piste principale 110 se raccorde sur le côté 131 de la piste de liaison 130 à l'extrémité de celui-ci adjacente à la base 133 de la piste 130. En revanche, le port d'entrée 120 se raccorde sur le côté 132 de la piste 130 au milieu de celui-ci.

Selon le mode de réalisation représenté sur les figures annexées, le circuit ouvert formé en sortie de la piste principale 110 est matérialisé par une plage électriquement conductrice 140 de contour rectangulaire. Les grands côtés de la piste 140 sont référencés 141, 142. Ces grands côtés 141, 142 s'étendent perpendiculairement à la direction D. Les petits côtés de la piste 140 sont référencés 143, 144. Ces petits côtés s'étendent parallèlement à la direction D.

La plage de sortie 140 formant circuit ouvert est reliée à la piste principale 110 par l'intermédiaire d'une plage de liaison électriquement conductrice 150.

La plage de liaison 150 a la forme d'un triangle rectangle. Le grand côté 151 de la plage de liaison 150 s'étend perpendiculairement à la direction D et se raccorde sur le petit côté 113 de la plage principale 110. De préférence, la longueur du côté 151 de la plage de liaison 150 est nettement supérieure à la longueur du petit côté 113 de la plage principale 110. La plage principale 110 est reliée avantageusement au côté 151 de la plage de liaison 150 au voisinage de l'extrémité de celui-ci adjacente à la base 153. Le petit côté 152 de la plage de liaison 150 s'étend parallèlement à la direction D. Il se raccorde au petit côté 143 du circuit de sortie 140. De préférence, le côté 152 de la plage de liaison 150 a une longueur supérieure à celle du petit côté 143 du circuit de sortie 140. La plage de sortie 140 est de préférence raccordée au côté 152 de la plage de liaison 150 à mi longueur de celui-ci.

En outre, selon le mode de réalisation représenté sur les figures annexées, le premier ensemble 100 comprend une piste additionnelle 160. La piste 160 a un contour rectangulaire. Les grands côtés 161, 162 de la piste additionnelle 160 s'étendent parallèlement à la direction D. Les petits côtés 163, 164 de la piste additionnelle 160 s'étendent perpendiculairement à la direction D. Plus précisément, le petit côté 164 de la piste additionnelle 160 se raccorde sur le grand côté 131 de la piste de liaison 130. Plus précisément encore, la piste additionnelle 160 se raccorde sur le grand côté 131 de la piste de liaison 130 au niveau de l'extrémité de celui-ci adjacente au côté 132.

En d'autres termes, la piste additionnelle 160 se raccorde à la piste de liaison 130 à proximité du port d'entrée 120.

Par ailleurs, selon le mode de réalisation représenté sur les figures annexées le premier ensemble 100 comprend également une autre piste additionnelle 170 qui se raccorde à la piste de liaison 150, c'est-à-dire qui se raccorde au premier ensemble à proximité du circuit de sortie 140. La piste 170 possède un contour général rectangulaire. Les grands côtés 171, 172 de la piste additionnelle 170 s'étendent parallèlement à la direction D. Les petits côtés 173, 174 de cette piste additionnelle 170 s'étendent perpendiculairement à la direction D. La piste additionnelle 170 se raccorde par son petit côté 174 sur le grand côté 151 de la piste de liaison 150. Plus précisément, la piste additionnelle 170 se raccorde à la piste de liaison 150 sur l'extrémité du côté 151 de celle-ci adjacente au côté 152.

Le second ensemble 200 comporte au moins une piste secondaire 210 en matériau électriquement conducteur, adjacente à ladite piste principale 110 pour être couplée à celle-ci, et qui aboutit à un port de sortie 220.

La piste secondaire 210 est placée entre la piste principale 110 et la piste additionnelle 170. Elle possède de préférence un contour général rectangulaire. Les grands côtés 211, 212 de la piste secondaire 210 s'étendent parallèlement à la direction D. Les petits côtés 213, 214 de la piste additionnelle 210 s'étendent perpendiculairement à la direction D.

Plus précisément, la piste secondaire 210 est placée de préférence à mi distance de la piste principale 110 et de la piste additionnelle 170. Par ailleurs, son extrémité 213 placée en regard de la piste de liaison 150 est située à une distance du côté 151 de celle-ci égale à la distance séparant les grands côtés 211, 212 de la piste secondaire 210 des côtés 112 et 172 respectivement en regard de la piste principale 110 et de la piste additionnelle 170.

Le port de sortie 220 est formé d'une plage électriquement conductrice de contour rectangulaire. Les grands côtés 221, 222 du port de sortie 220 s'étendent perpendiculairement à la direction D. Les petits côtés 223, 224 du port de sortie 220 s'étendent parallèlement à la direction D.

La piste secondaire 210 et le port de sortie 220 sont reliés par une plage de liaison 230 en matériau électriquement conducteur. La plage 230 a la forme d'un triangle rectangle isocèle. Ces côtés 231, 232 orthogonaux, respectivement perpendiculaire et parallèle à la direction D, se raccordent l'un au petit côté 214 de la piste secondaire 210, l'autre au petit côté 224 du port de sortie 220. Plus précisément, la piste secondaire 210 se raccorde sur le côté 214 de la piste de liaison 230 au voisinage de l'extrémité de celui-ci adjacente à la base 233 de la piste de liaison 230.

En revanche, le port de sortie 220 se raccorde sur le côté 232 de la piste de liason 230 sensiblement à mi longueur de celui-ci.

Le troisième ensemble 300 comprend au moins une piste auxiliaire 310 en matériau électriquement conducteur, adjacente à la piste principale 110, pour être couplée à celle-ci, et qui est reliée à une résistance de charge 320 de valeur contrôlée.

La piste auxiliaire 310 possède un contour rectangulaire. Ces grands côtés 311, 312 s'étendent parallèlement à la direction D. Les petits côtés 313, 314 de la piste auxiliaire 312 s'étendent perpendiculairement à la direction D.

La résistance 320 peut être formée de toute structure appropriée. Elle est avantageusement formée d'un dépôt en couche épaisse sur le substrat. En l'espèce, selon le mode de réalisation représenté sur les figures annexées, la résistance 320 est placée entre une plage de liaison 330 et une plage de connexion 340.

La plage de liaison 330 permet de relier une première extrémité de la résistance 320 et la piste auxiliaire 310. La plage de liaison 330 possède un contour en forme de triangle rectangle. Ces deux côtés orthogonaux 331, 332 sont respectivement parallèle à la direction D et perpendiculaire à celle-ci. La longueur du côté 332 est supérieure à la longueur du petit côté 314 de la piste auxiliaire 310. Le petit côté 314 de cette piste auxiliaire 310 se raccorde sur l'extrémité du côté 332 de la piste de liaison 330 adjacente à la base 333.

La résistance 320 se raccorde par ailleurs, sur le second côté 331 de la piste de liaison 330, de préférence à mi longueur de celui-ci.

La plage de connexion 340 peut être reliée à la masse ou laissée "en l'air". Elle a de préférence un contour rectangulaire. Les grands côtés 341, 342 de la piste de connexion 340 s'étendent parallèlement à la direction D. Les petits côtés 343, 344 de la piste de connexion 340 s'étendent perpendiculairement à cette direction D. La seconde extrémité de la résistance 320 se raccorde sur le grand côté 342 de la piste de connexion 340.

La piste auxiliaire 310 est ainsi placée entre la piste principale 110 et la piste additionnelle 160. Elle est de préférence située à mi distance entre cette piste principale 110 et la piste additionnelle 160. En outre, le petit côté 313 de la piste auxiliaire 310 est de préférence située à une distance du côté 131 de la piste de liaison 130 placée en regard, égale à la distance séparant respectivement les grands côtés 311, 312 de la piste auxiliaire 310 des grands côtés 111, 162 de la piste principale 110 et de la piste additionnelle 160 placées respectivement en regard.

On notera enfin que selon le mode de réalisation représenté sur les figures annexées, le port d'entrée 120 est encadré par deux plages rectangulaires de masse 180, 190, tandis que le port de sortie 220 est encadré par deux plages rectangulaires de masse 280, 290.

Ces plans de masse sont reliés au plan de masse de la face arrière à l'aide de trous métallisés, représentés sur la figure 1 par les cercles 181, 191 et 281 et 291.

L'élément de test conforme à la présente invention représenté sur les figures annexées présente une similitude avec un coupleur de Lange chargé par une résistance 320 au niveau de la piste auxiliaire 310 et par un circuit ouvert en extrémité de la piste principale 110. Le port d'entrée 120 et le port de sortie 220 sont utilisés comme port de mesure.

Le comportement de ce circuit peut être décrit de la manière suivante. Le port d'entrée 120 voit quasiment le circuit ouvert de la plage de sortie 140 ramené par le tronçon de la ligne centrale 110. Le port de sortie 220 possède un coefficient de réflexion un peu plus faible puisqu'une partie du couplage vient se rajouter au circuit ouvert au bout de la ligne 210 du port 220. Grâce à ces dispositions, on obtient des allures de courbe des paramètres S11 et S22 semblables à ceux d'un transistor à effet de champ en mode de fonctionnement normal. Le coefficient de transmission de ce dispositif est approximativement égal au facteur de couplage d'un coupleur de Lange, soit de l'ordre de 3 à 6 dB.

Les paramètres de l'élément de test représenté sur la figure 1 annexée, peuvent être ajustées en modifiant la valeur de la résistance de charge 320, la longueur des pistes 110, 160, 170, 310 et 210 et le nombre de doigts du coupleur ainsi formés, c'est-à-dire en modifiant le nombre de doigts enchevétrés des différents ensembles.

En résumé, l'élément de test conforme à la présente invention, comprend trois éléments fondamentaux :

- une structure de pistes ou lignes enchevétrées à la façon d'un coupleur de Lange, qui fixe la bande de fréquence utile dans laquelle on obtient une bonne transmission,
- un circuit ouvert dont la longueur de ligne joue à la fois sur le coefficient de réflexion en entrée et sur le couplage, et
- une résistance de charge 320 dont la valeur permet d'ajuster le coefficient de réflexion en sortie et de régler le coefficient de transmission.

Par rapport aux systèmes antérieurs connus, l'élément de test conforme à la présente invention offre notamment les avantages suivants :

- les paramètres de bruit obtenus sur l'élément de test conforme à la présente invention sont tout à fait comparables à ceux d'un transistor actif faible bruit à savoir un facteur de bruit minimal inférieur à 1dB, une résistance équivalente de bruit inférieure à 50 Ohms, un module du coefficient de réflexion optimal supérieur à 0,7 et une phase de ce coefficient de réflexion optimal supérieur à 0°.
- l'élément de test est utilisable sur une large bande puisqu'il peut être utilisé sans difficulté sur plus d'une octave.
- l'élément de test est extensible en fréquence. Il suffit de changer la longueur du coupleur de Lange, c'est-à-dire la longueur des pistes 110, 160, 170, 210, 310 et la valeur de résistance 320 pour modifier la plage d'utilisation.
- l'élément de test conforme à la présente invention peut être réalisé sur le même substrat de calibration des paramètres de dispersion (S) ce qui améliore la fiabilité des mesures et permet précision et reproductibilité.
- l'élément de test conforme à la présente invention présente un fort coefficient de réflexion en sortie ce qui augmente la correction du second étage (récepteur) et rend compte de la qualité de la calibration en bruit.
- l'élément de test conforme à la présente invention est relativement simple à réaliser et autorise un bon rendement de fabrication.
- l'élément de test conforme à la présente invention peut être réalisé sur le même substrat que les éléments de calibration des mesures de paramètres S, par exemple un substrat AsGa. Il peut servir d'élément de référence et de comparaison pour les bancs de mesure de bruit.

Les inventeurs ont réalisés un élément de test conforme à la représentation donnée sur la figure 1 annexée sur un substrat d'alumine d'une épaisseur de 635µ métallisé sur les deux faces. La métallisation d'une épaisseur de 4µm était formée de NiCr+Au. La résistivité de la face circuit dans laquelle sont formées les diverses pistes électriquement conductrices représentées sur la figure 1 est de 50 Ohms/carré.

Plus précisément encore, l'élément de test réalisé répondait aux valeurs dimensionnelles suivantes :

- longueur des côtés 111, 112 de la piste principale 110 : 0,77mm.
- largeur de la piste principale 110 : 0,2mm.
- longueur des côtés 121, 122 du port d'entrée 120 0,885mm.
- largeur du port d'entrée 120 : 0,052mm.
- longueur du côté 131 de la piste de liaison 130 0,74mm.
- longueur du côté 132 de la piste de liaison 130 0,41mm.
- longueur des côtés 141, 142 du circuit 140 : 0,21mm.
- longueur des côtés 143, 144 du circuit 140 : 0,41mm.
- piste 150 de liaison de même dimension que la piste de liaison 130.
- longueur des côtés 161, 162 de la piste additionnelle 160 : 0,42mm.
- largeur de la piste additionnelle 160 : 0,2mm.
- piste additionnelle 170 de même dimension que la piste additionnelle 160.
- longueur des côtés 211, 212 de la piste secondaire 210 : 0,70mm.
- largeur de la piste secondaire 210 : 0,2mm.
- longueur du côté 231 de la piste de liaison 230 0,47mm.
- longueur du côté 232 de la piste de liaison 230

0,41mm.

- port de sortie 220 de même dimension que le port d'entrée 120.
- piste auxiliaire 310 de même dimension que la piste secondaire 210.
- piste de liaison 330 de même dimension que la piste de liaison 230,
- longueur du côté 343 de la plage de sortie 340 0,335mm.
- longueur du côté 341 de la piste de sortie 340 : 0,41mm.
- longueur de la résistance 320 : 0,6mm.
- largeur de la résistance 320 : 0,06mm.
- dimension de chaque plage de masse 180, 190, 280, 290 : 0,45x0,65mm.
- intervalle entre les différents "doigts" 110, 160, 170, 210, 310 du dispositif : 0,07mm.

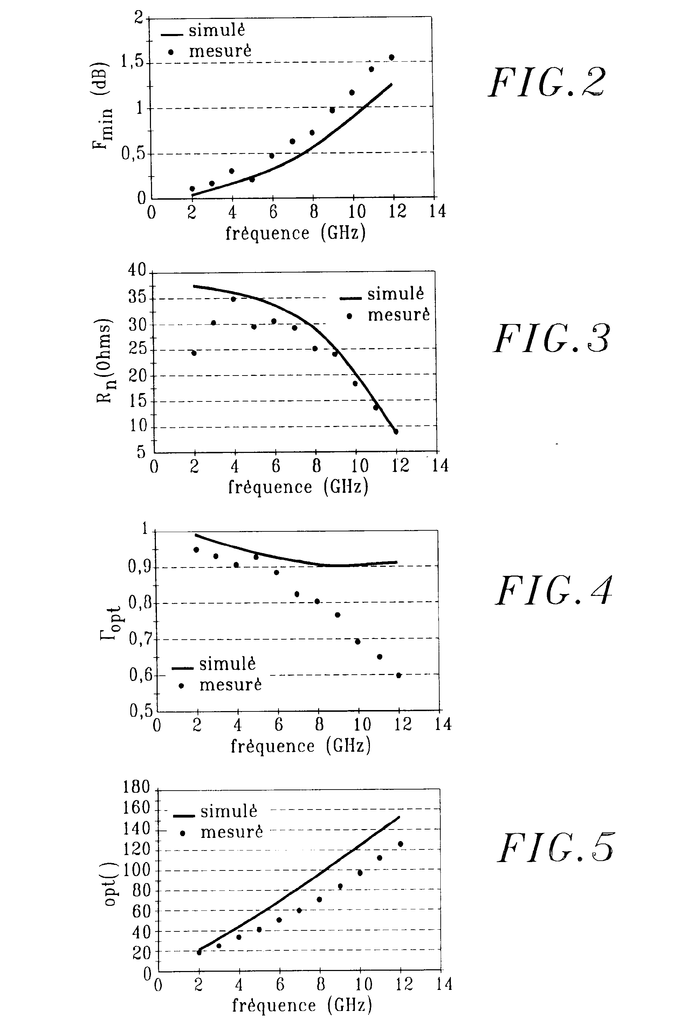

Les figures 2, 3, 4 et 5 représentent respectivement le facteur de bruit minimal, la résistance équivalente de bruit, le module du coefficient de réflexion optimal et la phase de ce coefficient de réflexion optimal résultant de la simulation à l'aide d'un logiciel HP-MDS, comparées aux mesures faites à l'aide d'un banc de mesure sur un élément de test conforme à la présente invention.

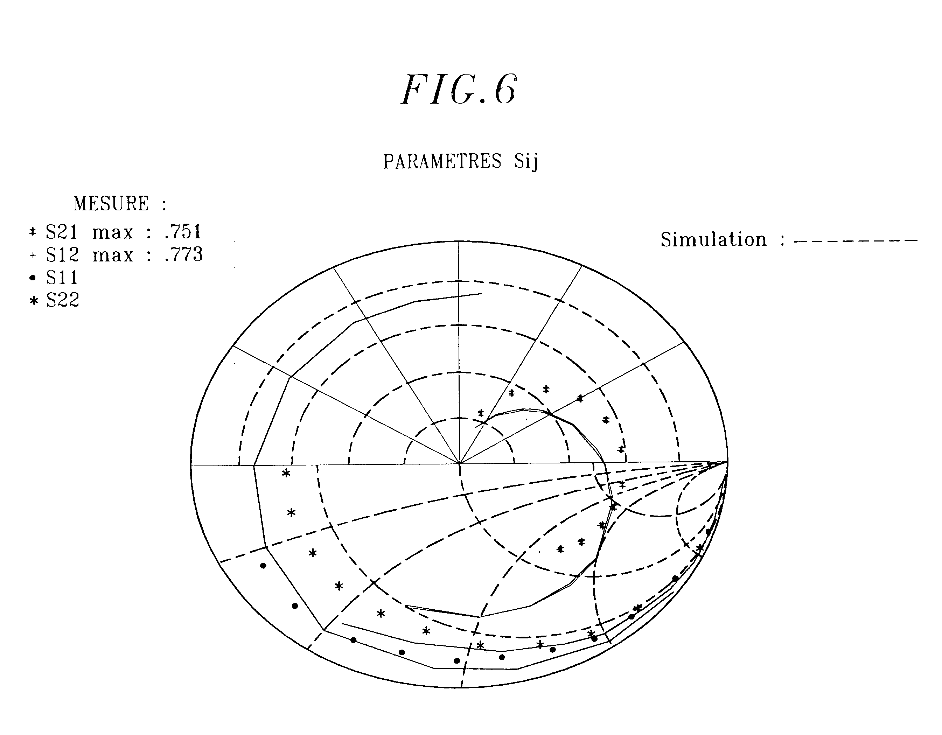

La figure 6 représente les paramètres Sij mesurés et simulés dans les mêmes conditions.

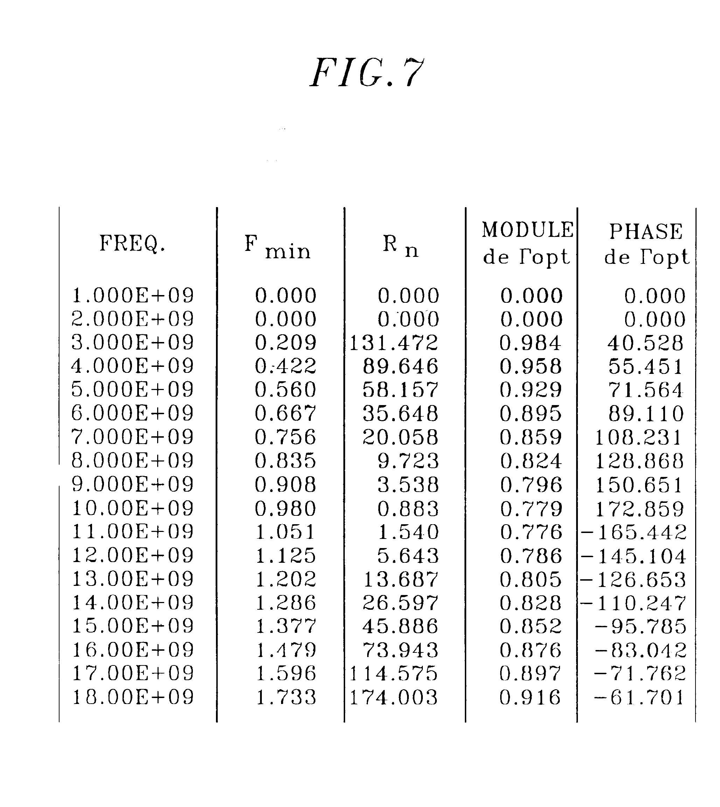

Les figures 7, 8, 9 et 10 représentent des tableaux indiquant les valeurs des quatre paramètres de bruit : facteur de bruit minimal, résistance équivalente de bruit, module du coefficient de réflexion optimal et phase de ce coefficient de réflexion optimal résultant de simulations sur un élément de test conforme à la présente invention, en faisant varier les conditions de charge sur la piste auxiliaire 310.

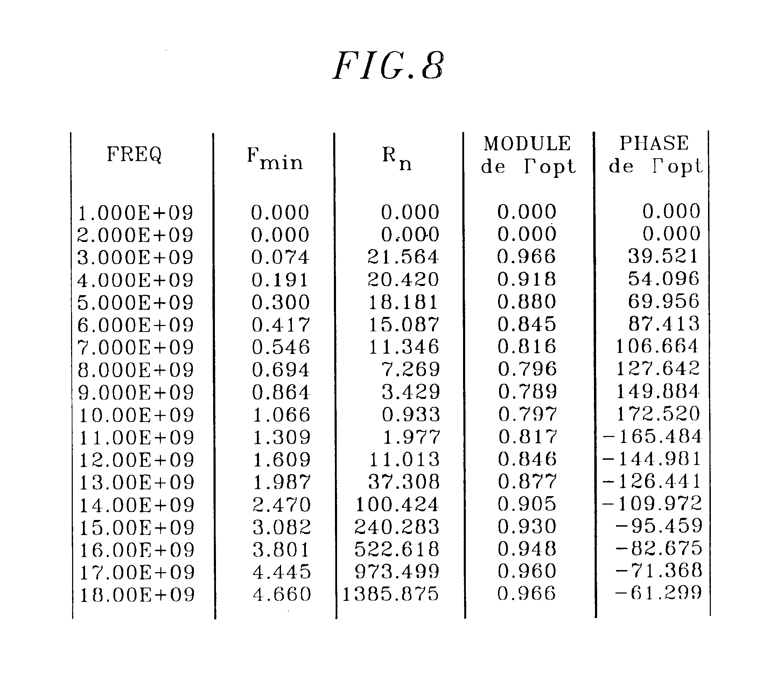

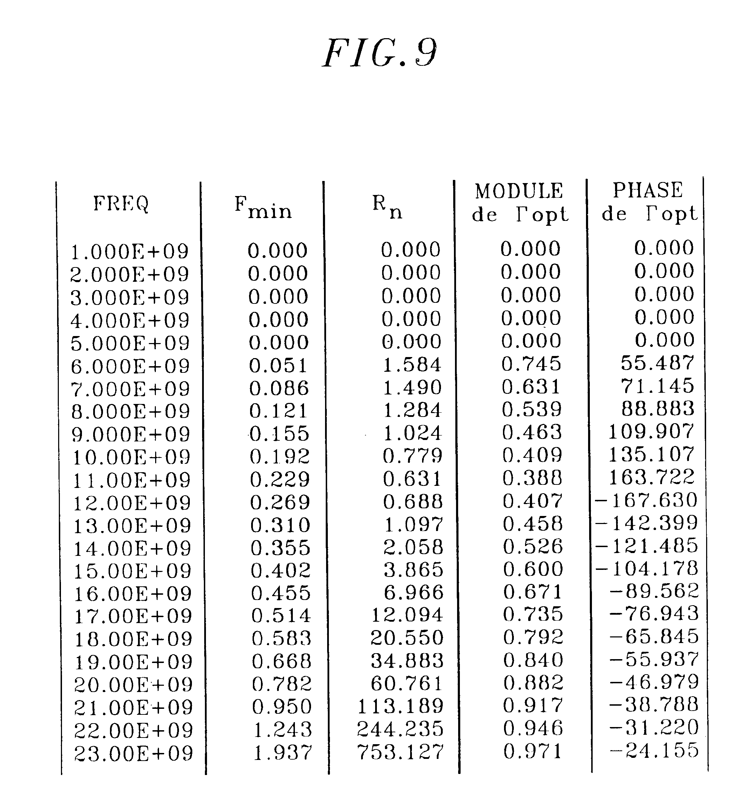

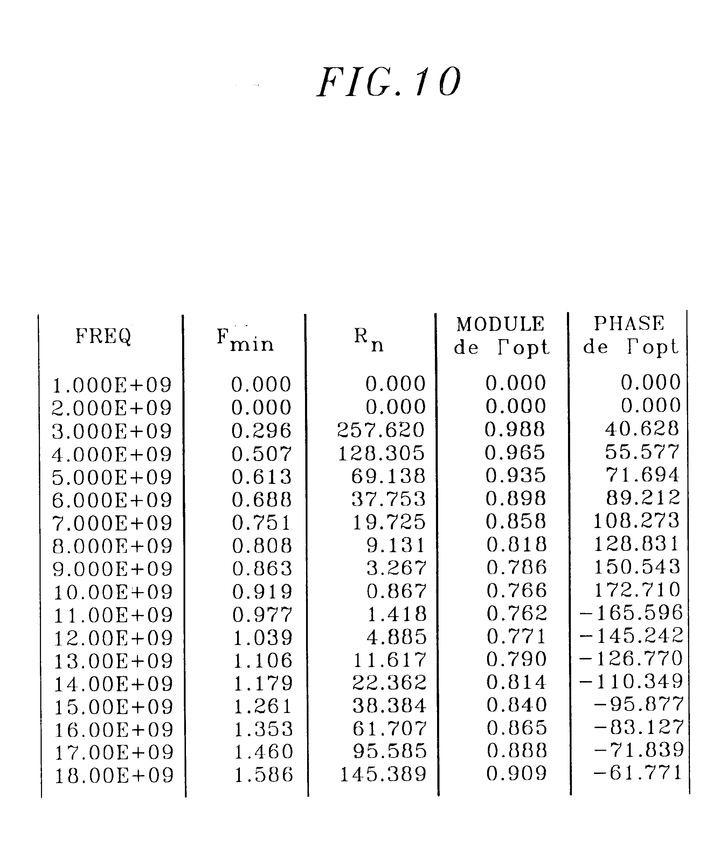

Plus précisément, le tableau de la figure 7 correspond à une résistance R320 en l'air d'une valeur 500 Ohms, le tableau de la figure 8 correspond à une résistance R320 en l'air de 50 Ohms, le tableau de la figure 9 correspond à un circuit ouvert en sortie de la piste auxiliaire 310 à la place de la résistance de charge 320 et le tableau de la figure 10 correspond à une résistance de charge 320 d'une valeur de 500 Ohms connectée à la masse au niveau de la plage 340.

Bien entendu, l'élément de test conforme à la présente invention peut être utilisé avec tout banc de mesure de bruit connu.

La présente invention n'est pas limitée au mode de réalisation particulier qui vient d'être décrit mais s'étend à toute variante conforme à son esprit.

**Revendications**

1. Elément de test passif simulant le comportement au bruit d'un transistor, caractérisé par le fait qu'il comprend sur un substrat électriqument isolant :
   - un premier ensemble (100) comportant au moins une piste principale (110) en matériau électriquement conducteur, reliée à un port d'entrée (120), et aboutissant sur un circuit ouvert (140),
   - un second ensemble (200) comportant au moins une piste secondaire (210) en matériau électriquement conducteur, adjacente à ladite piste pricipale (110) pour être couplée à celle-ci, et qui aboutit à un port de sortie (220), et
   - un troisième ensemble (300) comportant au moins une piste auxiliaire (310) en matériau électriquement conducteur, adjacente à ladite piste principale (110) pour être couplée à celle-ci, et qui est reliée à une résistance de charge (320) de valeur contrôlée.

2. Elément de test selon la revendication 1, caractérisé par le fait que le premier ensemble (100) comprend en outre au moins une piste additionnelle (170) et par le fait que la piste secondaire (210) est placée entre la piste principale (110) et cette pidyr additionnelle (170).

3. Elément de test selon la revendication 2, caractérisé par le fait que la piste additionnelle (170) se raccorde à la piste principale (110) au voisinage du circuit ouvert (140).

4. Elément de test selon l'une des revendications 2 ou 3, caractérisé par le fait que la piste principale (110) et la piste additionnelle (170) présentent des contours rectangulaires dont les grandes longueurs sont parallèles entre elles.

5. Elément de test selon l'une des revendications 1 à 4, caractérisé par le fait que le premier ensemble (100) comprend en outre une piste additionnelle (160) et par le fait que la piste auxiliaire (310) est placée entre la piste principale (110) et la piste additionnelle (160).

6. Elément de test selon la revendication 5, caractérisé par le fait que la piste additionnelle (160) se raccorde à la piste principale (110) au voisinage du port d'entrée (120).

7. Elément de test selon l'une des revendications 5 et 6, caractérisé par le fait que la piste principale (110) et la piste additionnelle (160) ont des contours rectangulaires dont les grandes longueurs sont parallèles entre elles.

8. Elément de test selon l'une des revendications 1 à 7, caractérisé par le fait qu'une plage électriquement conductrice de contour triangulaire relie le port d'entrée (120) à la piste principale (110).

**9.** Elément de test selon l'une des revendications 1 à 8, caractérisé par le fait qu'une plage électriquement conductrice (150) de contour triangulaire relie une plage (140) formant circuit ouvert à la piste principale (110).

**10.** Elément de test selon l'une des revendications 3 ou 6, caractérisé par le fait que chaque piste additionnelle (160, 170) est reliée à la piste principale (110) par l'intermédiaire d'une piste de liaison électriquement conductrice de contour triangulaire (130, 150).

**11.** Elément de test selon l'une des revendications 1 à 10, caractérisé par le fait que la piste secondaire (210) est reliée au port de sortie (220) par l'intermédiaire d'une plage électriquement conductrice de contour triangulaire (230).

**12.** Elément de test selon l'une des revendications 1 à 11, caractérisé par le fait que la résistance de charge (320) est reliée à la piste auxiliaire (310) par l'intermédiaire d'une piste électriquement conductrice de contour triangulaire (330).

**13.** Elément de test selon l'une des revendications 1 à 12, caractérisé par le fait que la seconde extrémité de la résistance de charge (320) du troisième ensemble (300) est en l'air.

**14.** Elément de test selon l'une des revendications 1 à 12, caractérisé par le fait que la seconde extrémité de la résistance de charge (320) du troisième ensemble (300) est reliée à la masse.

FIG. 1

*FIG.2*

*FIG.3*

*FIG.4*

*FIG.5*

# FIG.6

PARAMETRES Sij

MESURE :

‡ S21 max : .751
+ S12 max : .773
• S11
* S22

Simulation : — — — — — —

EP 0 594 488 A1

# *FIG.7*

| FREQ. | $F_{min}$ | $R_n$ | MODULE de Γopt | PHASE de Γopt |
|---|---|---|---|---|
| 1.000E+09 | 0.000 | 0.000 | 0.000 | 0.000 |
| 2.000E+09 | 0.000 | 0.000 | 0.000 | 0.000 |
| 3.000E+09 | 0.209 | 131.472 | 0.984 | 40.528 |
| 4.000E+09 | 0.422 | 89.646 | 0.958 | 55.451 |
| 5.000E+09 | 0.560 | 58.157 | 0.929 | 71.564 |
| 6.000E+09 | 0.667 | 35.648 | 0.895 | 89.110 |
| 7.000E+09 | 0.756 | 20.058 | 0.859 | 108.231 |
| 8.000E+09 | 0.835 | 9.723 | 0.824 | 128.868 |
| 9.000E+09 | 0.908 | 3.538 | 0.796 | 150.651 |
| 10.00E+09 | 0.980 | 0.883 | 0.779 | 172.859 |
| 11.00E+09 | 1.051 | 1.540 | 0.776 | −165.442 |
| 12.00E+09 | 1.125 | 5.643 | 0.786 | −145.104 |
| 13.00E+09 | 1.202 | 13.687 | 0.805 | −126.653 |
| 14.00E+09 | 1.286 | 26.597 | 0.828 | −110.247 |
| 15.00E+09 | 1.377 | 45.886 | 0.852 | −95.785 |
| 16.00E+09 | 1.479 | 73.943 | 0.876 | −83.042 |
| 17.00E+09 | 1.596 | 114.575 | 0.897 | −71.762 |
| 18.00E+09 | 1.733 | 174.003 | 0.916 | −61.701 |

# FIG.8

| FREQ | $F_{min}$ | $R_n$ | MODULE de $\Gamma$opt | PHASE de $\Gamma$opt |
|---|---|---|---|---|
| 1.000E+09 | 0.000 | 0.000 | 0.000 | 0.000 |
| 2.000E+09 | 0.000 | 0.000 | 0.000 | 0.000 |
| 3.000E+09 | 0.074 | 21.564 | 0.966 | 39.521 |
| 4.000E+09 | 0.191 | 20.420 | 0.918 | 54.096 |
| 5.000E+09 | 0.300 | 18.181 | 0.880 | 69.956 |
| 6.000E+09 | 0.417 | 15.087 | 0.845 | 87.413 |
| 7.000E+09 | 0.546 | 11.346 | 0.816 | 106.664 |
| 8.000E+09 | 0.694 | 7.269 | 0.796 | 127.642 |
| 9.000E+09 | 0.864 | 3.429 | 0.789 | 149.884 |
| 10.00E+09 | 1.066 | 0.933 | 0.797 | 172.520 |
| 11.00E+09 | 1.309 | 1.977 | 0.817 | −165.484 |
| 12.00E+09 | 1.609 | 11.013 | 0.846 | −144.981 |
| 13.00E+09 | 1.987 | 37.308 | 0.877 | −126.441 |
| 14.00E+09 | 2.470 | 100.424 | 0.905 | −109.972 |
| 15.00E+09 | 3.082 | 240.283 | 0.930 | −95.459 |
| 16.00E+09 | 3.801 | 522.618 | 0.948 | −82.675 |
| 17.00E+09 | 4.445 | 973.499 | 0.960 | −71.368 |
| 18.00E+09 | 4.660 | 1385.875 | 0.966 | −61.299 |

# FIG.9

| FREQ | $F_{min}$ | $R_n$ | MODULE de Γopt | PHASE de Γopt |
|---|---|---|---|---|
| 1.000E+09 | 0.000 | 0.000 | 0.000 | 0.000 |
| 2.000E+09 | 0.000 | 0.000 | 0.000 | 0.000 |
| 3.000E+09 | 0.000 | 0.000 | 0.000 | 0.000 |
| 4.000E+09 | 0.000 | 0.000 | 0.000 | 0.000 |
| 5.000E+09 | 0.000 | 0.000 | 0.000 | 0.000 |
| 6.000E+09 | 0.051 | 1.584 | 0.745 | 55.487 |
| 7.000E+09 | 0.086 | 1.490 | 0.631 | 71.145 |
| 8.000E+09 | 0.121 | 1.284 | 0.539 | 88.883 |
| 9.000E+09 | 0.155 | 1.024 | 0.463 | 109.907 |
| 10.00E+09 | 0.192 | 0.779 | 0.409 | 135.107 |
| 11.00E+09 | 0.229 | 0.631 | 0.388 | 163.722 |
| 12.00E+09 | 0.269 | 0.688 | 0.407 | −167.630 |
| 13.00E+09 | 0.310 | 1.097 | 0.458 | −142.399 |
| 14.00E+09 | 0.355 | 2.058 | 0.526 | −121.485 |
| 15.00E+09 | 0.402 | 3.865 | 0.600 | −104.178 |
| 16.00E+09 | 0.455 | 6.966 | 0.671 | −89.562 |
| 17.00E+09 | 0.514 | 12.094 | 0.735 | −76.943 |
| 18.00E+09 | 0.583 | 20.550 | 0.792 | −65.845 |
| 19.00E+09 | 0.668 | 34.883 | 0.840 | −55.937 |
| 20.00E+09 | 0.782 | 60.761 | 0.882 | −46.979 |
| 21.00E+09 | 0.950 | 113.189 | 0.917 | −38.788 |
| 22.00E+09 | 1.243 | 244.235 | 0.946 | −31.220 |
| 23.00E+09 | 1.937 | 753.127 | 0.971 | −24.155 |

# FIG.10

| FREQ | $F_{min}$ | $R_n$ | MODULE de $\Gamma$opt | PHASE de $\Gamma$opt |
|---|---|---|---|---|
| 1.000E+09 | 0.000 | 0.000 | 0.000 | 0.000 |
| 2.000E+09 | 0.000 | 0.000 | 0.000 | 0.000 |
| 3.000E+09 | 0.296 | 257.620 | 0.988 | 40.628 |
| 4.000E+09 | 0.507 | 128.305 | 0.965 | 55.577 |
| 5.000E+09 | 0.613 | 69.138 | 0.935 | 71.694 |
| 6.000E+09 | 0.688 | 37.753 | 0.898 | 89.212 |
| 7.000E+09 | 0.751 | 19.725 | 0.858 | 108.273 |
| 8.000E+09 | 0.808 | 9.131 | 0.818 | 128.831 |
| 9.000E+09 | 0.863 | 3.267 | 0.786 | 150.543 |
| 10.00E+09 | 0.919 | 0.867 | 0.766 | 172.710 |
| 11.00E+09 | 0.977 | 1.418 | 0.762 | −165.596 |
| 12.00E+09 | 1.039 | 4.885 | 0.771 | −145.242 |
| 13.00E+09 | 1.106 | 11.617 | 0.790 | −126.770 |
| 14.00E+09 | 1.179 | 22.362 | 0.814 | −110.349 |
| 15.00E+09 | 1.261 | 38.384 | 0.840 | −95.877 |
| 16.00E+09 | 1.353 | 61.707 | 0.865 | −83.127 |
| 17.00E+09 | 1.460 | 95.585 | 0.888 | −71.839 |
| 18.00E+09 | 1.586 | 145.389 | 0.909 | −61.771 |

Office européen
des brevets

## RAPPORT DE RECHERCHE EUROPEENNE

Numero de la demande

EP    93 40 2553
PAGE1

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A,D | ELECTRONICS LETTERS<br>vol. 27, no. 10, Mai 1991, LONDON GB<br>pages 833 - 835<br>L.ESCOTTE ET AL. 'Using cold FET to check accuracy of microwave noise parameter test set'<br>* page 833, colonne de droite *<br>--- | 1 | G01R31/26<br>G01R29/26<br>G01R35/00 |
| A | MICROWAVE JOURNAL.<br>vol. 31, no. 11, Novembre 1988, NORWOOD,MA US<br>pages 172 - 176<br>A.FRASER ET AL. 'Repeatability and Verification of On-Wafer Noise Parameter Measurements'<br>* page 172, colonne du milieu, alinéa 2 - colonne de droite, alinéa 1 *<br>* page 173, colonne du milieu, alinéa 2 - colonne de droite, alinéa 1 *<br>* page 175, colonne de droite, alinéa 1 - page 176, colonne de droite, alinéa 4; figure 7 *<br>--- | 1 | |
| A | IEEE TRANSACTIONS ON INSTRUMENTATION AND MEASUREMENT<br>vol. 39, no. 6, Décembre 1990, NEW YORK US<br>pages 958 - 961<br>G.REEVE ET AL. 'Microwave Monolithic Integrated Circuit-Related Metrology at the National Institute of Standards and Technology'<br>* page 959, colonne de droite, dernier alinéa - page 960, colonne de gauche, alinéa 1; figure 3 *<br>* page 960, colonne de droite, dernier alinéa - page 961, colonne de droite, alinéa 2 *<br>---<br>-/-- | 1 | **DOMAINES TECHNIQUES RECHERCHES (Int. Cl.5)**<br><br>G01R |

Le présent rapport a été établi pour toutes les revendications

| Lieu de la recherche | Date d'achèvement de la recherche | Examinateur |
|---|---|---|
| BERLIN | 11 JANVIER 1994 | FRITZ S. |

EPO FORM 1503 03.82 (P0402)

15

**Office européen des brevets**

# RAPPORT DE RECHERCHE EUROPEENNE

Numero de la demande

EP    93 40 2553
PAGE2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | ARCHIV FUR ELEKTRONIK UND UBERTRAGUNGSTECHNIK vol. 46, no. 2, Mars 1992, STUTTGART DE pages 111 - 116 J.WENGER 'Investigations on Microwave Noise Parameters of GaAs-Based Heterojunction FETs for Low-Noise MMIC-Amplifiers' * page 113, colonne de gauche, alinéa 1 * * page 114, colonne de droite, dernier alinéa  - page 115, colonne de droite, alinéa 2 * | 1 | |
| A,D | IEEE TRANSACTIONS ON MICROWAVE THEORY AND TECHNIQUES vol. 37, no. 12, Décembre 1989, NEW YORK US pages 1973 - 1977 A.C.DAVIDSON ET AL. 'Accuracy Improvements in Microwave Noise Parameter Measurements' * page 1976, colonne de droite; figure 12 * | 1 | |

**DOMAINES TECHNIQUES RECHERCHES (Int. Cl.5 )**

Le présent rapport a été établi pour toutes les revendications

| Lieu de la recherche | Date d'achèvement de la recherche | Examinateur |
|---|---|---|
| BERLIN | 11 JANVIER 1994 | FRITZ S. |

EPO FORM 1503 03.82 (P0402)